Europäisches Patentamt

European Patent Office

Office européen des brevets

(19)

(12)

Numéro de publication: **0 308 560**
**A1**

# DEMANDE DE BREVET EUROPEEN

(21) Numéro de dépôt: 87402112.4

(22) Date de dépôt: **22.09.87**

(51) Int. Cl.4: **H01J 37/06 , H01J 37/08 , H01J 37/073**

(43) Date de publication de la demande:
**29.03.89 Bulletin 89/13**

(84) Etats contractants désignés:
**AT BE CH DE GB IT LI LU NL SE**

(71) Demandeur: **UNIVERSITE DE REIMS CHAMPAGNE ARDENNE**
**23, rue Boulard**
**F-51100 Reims(FR)**

(72) Inventeur: **Troyon, Michel**
**9, rue de la Tuilerie**
**F-51390 Gueux(FR)**

(74) Mandataire: **Martin, Jean-Jacques et al**
**Cabinet REGIMBEAU 26, Avenue Kléber**
**F-75116 Paris(FR)**

(54) Canon à particules électriques permettant l'émission pulsée de particules d'énergie déterminée.

(57) L'invention concerne un canon à particules élec-triques, électrons ou ions.

Le canon comporte une source (1) d'émission de particules électriques, des moyens de pré-accélération (2) des particules. Une électrode retar-datrice (3) est disposée au voisinage des moyens de pré-accélération (2) et est reliée à un circuit d'excitation (4) permettant l'émission pulsée de particules d'énergie comprise dans une bande d'énergie déterminée et le filtrage en énergie de celles-ci.

Application à la microlithographie électronique ou ionique, à l'industrie des circuits intégrés.

FIG-1a

EP 0 308 560 A1

# CANON A PARTICULES ELECTRIQUES PERMETTANT L'EMISSION PULSEE DE PARTICULES D'ENERGIE DETERMINEE.

La présente invention est relative à un canon à particules électriques permettant d'engendrer des faisceaux de particules filtrées en énergie et pulsés.

Actuellement, les techniques de microlithographie électronique ou ionique font appel pour la gravure de circuits à graver en accord avec un modèle ou figure de référence à des faisceaux électroniques ou ioniques pulsés. Pour tester les circuits ainsi obtenus, le faisceau de particules doit être un faisceau pulsé à grande fréquence de répétition. Ces faisceaux pulsés sont obtenus à l'aide de systèmes permettant de bloquer ou au contraire d'autoriser la transmission du faisceau de particules. Les systèmes actuellement utilisés mettent en oeuvre des plaques de condensateurs, des cavités résonantes ou des lentilles électrostatiques unipotentielles. Des systèmes décrivant l'utilisation de lentilles électrostatiques unipotentielles ont fait l'objet d'une publication notamment par le brevet US 4 439 685. Dans ce système, la lentille unipotentielle est disposée après une première lentille de focalisation de la colonne optique de focalisation portée au potentiel de référence la lentille unipotentielle est ainsi totalement séparée de la source de particules électriques.

La présente invention a pour but la mise en oeuvre d'un canon à particules électriques multifonctions permettant d'engendrer des faisceaux de particules électriques pulsés à très grande fréquence de commutation.

Un autre objet de la présente invention est la mise en oeuvre d'un canon à particules électriques permettant d'assurer à la fois le filtrage en énergie de ces particules électriques pour obtenir un faisceau ayant une dispersion en énergie réduite et ou l'émission pulsée à haute fréquence de commutation.

Un autre objet de la présente invention est la mise en oeuvre d'un canon à particules électriques susceptible d'être intégré à des systèmes accélérateurs à plusieurs étages.

Le canon à particules électriques, objet de l'invention comprend, dans une enceinte d'émission, une source d'émission de particules électriques et des moyens de pré-accélération et de focalisation de ces particules.

Il est remarquable en ce qu'il comprend en outre, au voisinage des moyens de focalisation, une électrode retardatrice reliée électriquement à un circuit d'excitation permettant l'émission pulsée de particules d'énergie comprise dans une bande d'énergie déterminée.

L'invention trouve application en microlithographie électronique ou ionique, dans l'industrie des circuits intégrés.

Elle sera mieux comprise à la lecture de la description et à l'observation des dessins ci-après, dans lesquels :

- les figures 1a et 1b représentent des schémas de principe relatifs à des canons à particules électriques conformes à la présente invention,

- la figure 2 est un diagramme en forme d'histogramme des particules électriques en fonction de leur énergie par rapport aux différents potentiels des électrodes du canon, objet de l'invention, diagramme permettant de comprendre le fonctionnement du canon à particules, objet de l'invention, tel que représenté en figures 1a et 1b,

- la figure 3 représente dans le cas où les particules émises sont des électrons, un canon à électrons à émission de champ conforme à la présente invention.

- la figure 4 représente un mode de réalisation particulièrement avantageux d'un canon à particules électriques, conforme à la présente invention, dans le cas où, les particules émises étant des électrons, une très grande fréquence de commutation peut être atteinte du fait de la très faible capacité électrostatique obtenue entre électrodes,

- la figure 5 représente une variante de réalisation du canon à particules électriques de la figure 3, dans lequel les moyens de pré-accélération sont constitués par une lentille électrostatique.

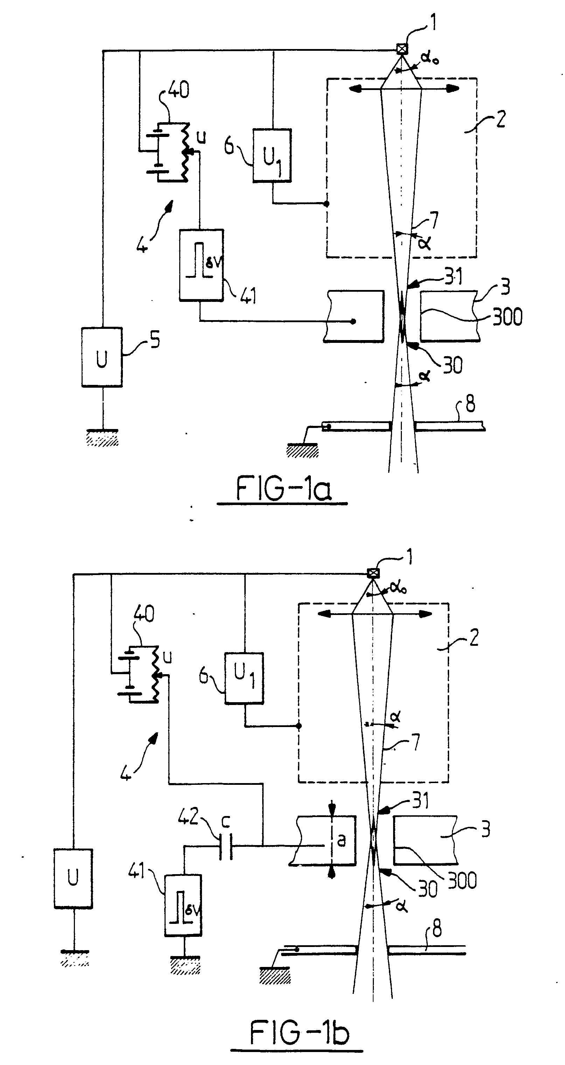

Le canon à particules électriques, objet de l'invention, sera tout d'abord décrit en liaison avec les figures 1a et 1b.

. Conformément à la figure 1a, le canon à particules électriques, objet de l'invention, comprend dans une enceinte d'émission, non représentée sur cette figure, une source d'émission, notée 1, de particules électriques et des moyens de pré-accélération et de focalisation, notés 2, de ces particules.

Au voisinage des moyens de focalisation 2, une électrode retardatrice 3 est reliée électriquement à un circuit d'excitation 4, permettant l'émission pulsée de particules d'énergie comprise dans une bande d'énergie déterminée et le filtrage en énergie de celles-ci.

Conformément à l'invention, le circuit 4 permet l'application à l'électrode retardatrice 3 d'un signal d'excitation consistant en une tension continue de niveau déterminé, notée u, à laquelle est superposée une impulsion ou un train d'impulsions d'amplitude δV permettant le blocage des particules.

Par canon à particules électriques, on entend canon à électrons, dans lequel les particules électriques émises sont des électrons,ou canon à ions, les particules électriques émises étant alors des ions chargés positivement ou négativement. Dans le cas d'un canon à électrons, l'enceinte d'émission est, de manière connue une enceinte à vide électronique, alors que dans le cas d'un canon à ions, l'enceinte d'émission peut consister en une enceinte à vide, dans le cas où le canon à ions permet l'émission d'ions par émission de champ à partir d'un métal déposé sur la cathode de la source, ou en une enceinte dans laquelle un gaz à ioniser est introduit. Une description plus détaillée de la structure des canons à électrons ou à ions susceptible d'être utilisée sera donnée ultérieurement dans la description.

Selon le premier mode de réalisation de la figure 1a, le circuit d'excitation 4 comprend, connecté en cascade, un générateur 40 de tension continue ajustable délivrant une tension de polarisation u par rapport à la tension de référence, et un générateur d'impulsions 41, délivrant une ou plusieurs impulsions d'amplitude δV.

Selon un deuxième mode de réalisation du circuit d'excitation 4, ainsi que représenté en figure 1b, celui-ci comprend un générateur 40 de tension continue ajustable u, relié à l'électrode retardatrice 3, et un générateur d'impulsions, délivrant des impulsions d'amplitude δV reliées à l'électrode retardatrice 3, par un élément capacitif 42.

Dans le cas où les particules électriques émises sont chargées négativement, comme dans le cas de l'émission d'électrons, la source d'émission 1 est polarisée négativement à une valeur U par rapport à la tension de référence. La source 1 est au contraire polarisée positivement, à une valeur U par rapport à la tension de référence, dans le cas où les particules émises sont chargées positivement. La tension U est délivrée par un générateur continu de type classique, les valeurs typiques de la tension de polarisation U pouvant atteindre quelques dizaines de kilovolts par rapport à la tension de référence.

Les moyens de pré-accélération et de focalisation 2 des particules, constitués par une lentille pré-accélératrice, notée 2, sont agencés de façon que la lentille pré-accélératrice 2 soit polarisée d'une part positivement, par l'intermédiaire d'un générateur continu délivrant une tension U1 par rapport à la tension de référence, dans le cas de l'émission de particules électriques chargées négativement. La lentille pré-accélératrice 2 est d'autre part polarisée négativement par le générateur continu 6 précité , à la valeur U1, par rapport à la tension de référence, dans le cas de l'émission de particules électriques chargées positivement.

Conformément à la présente invention, l'électrode retardtatrice 3 est polarisée par rapport à la source d'émission 1 à une tension continue faible de zéro à quelques volts, positive ou négative, selon la charge positive ou négative des particules émises.

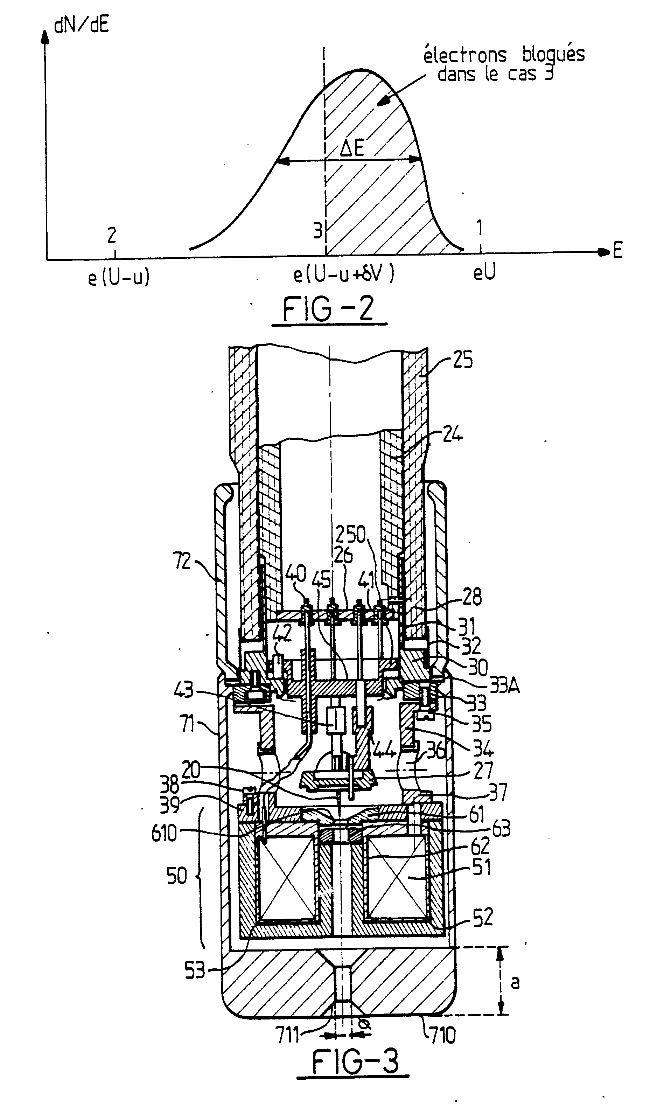

Le fonctionnement du canon à particules électriques, objet de l'invention, sera décrit en liaison avec la figure 2.

Sur la figure 2, on a représenté un histogramme de répartition du nombre de particules électriques émises, ou de la dérivée de ce nombre, en fonction de l'énergie d'accélération des particules électriques dans le canon. La courbe représentée en figure 2 est représentative du spectre d'énergie des particules électriques, contenues dans le faisceau de particules représenté en 7 sur les figures 1a et 1b, pour une tension d'accélération U, délivrée par le générateur continu 5, par rapport à une ou plusieurs anodes accélératrices représentées schématiquement sur les figures 1a et 1b en 8.

Dans le cas où l'électrode retardatrice 3 est polarisée à une valeur de potentiel égale à U, le niveau d'énergie correspondant étant noté eU,1 on suppose que toutes les particules électriques émises par le source d'émission 1 traversent l'électrode retardatrice 3, pour atteindre la ou les anodes 8. Dans ce cas, toutes les particules qui ont une énergie E supérieure en valeur absolue à eU peuvent traverser l'électrode retardatrice. On comprendra que dans le cas de particules chargées négativement ou électrons, l'énergie E est inférieure en valeur et en signe à la valeur eU où e désigne la charge élémentaire de l'électron en valeur et en signe, alors que dans le cas de particules électriques positives, l'énergie E est supérieure à la valeur eU.

Dans le cas où l'on superpose une tension u par l'intermédiaire du générateur de tension continue 40, par exemple, le niveau d'énergie relatif de l'électrode retardatrice 3 est amené par rapport aux niveaux d'énergie des particules du faisceau, à une valeur e (U-u) correspondant au point 2 de la figure 2. Dans ce cas, le niveau d'énergie relatif de l'électrode retardatrice 3 est en valeur absolue supérieur aux niveaux d'énergie des particules contenues dans le faisceau de particules 7, ce dernier se trouvant bloqué par l'électrode retardatrice 3.

Dans le cas où,à la tension u délivrée par le générateur de tension continue 40, l'on superpose une impulsion d'amplitude δV, le niveau d'énergie relatif de l'électrode retardatrice 3, en présence de l'impulsion appliquée, devient e (U-u + δV) et correspond au point 3 de la figure 2 en fonction de la valeur de l'amplitude des impulsions δV. Dans ce dernier cas, toutes les particules électriques ayant une énergie supérieure en valeur absolue à la valeur d'énergie relative de l'électrode retardatrice 3 correspondante au point 3 de la figure 2, seront transmises par l'électrode retardatrice 3 pendant la durée de l'impulsion, alors que toutes autres particules électriques, dont l'énergie est en valeur absolue inférieure au niveau relatif d'énergie de l'électrode retardatrice 3 en présence d'impulsions, niveau e(U-u + δV),seront bloquées par l'électrode retardatrice 3. Sur la figure 2, les particules électriques bloquées sont représentées par la partie hachurée dans le cas où les particules électriques émises sont des électrons, et où la tension u engendrée par le générateur de tension continue 40 est une tension négative.

Afin d'assurer un fonctionnement optimal du canon à particules électriques, objet de l'invention, notamment en ce qui concerne les conditions d'aberration chromatique, les différents éléments constitutifs du canon à particules représentés en figures 1a et 1b, peuvent être agencés de façon que le faisceau de particules 7 pénètre l'électrode retardatrice 3 sous un demi-angle de focalisation α présentant un rapport inférieur à $\frac{1}{5}$ relativement au demi-angle d'émission α0 des particules, à l'entrée de la lentille pré-accélératrice 2. Par construction, on choisira donc de disposer la source 1 et l'électrode retardatrice 3, en fonction des paramètres de fonctionnement de la lentille pré-accélératrice 2, de façon à réaliser cette condition.

En outre, le faisceau de particules 7 peut avantageusement être focalisé par la lentille pré-accélératrice 2, au point nodal objet 30, de l'électrode retardatrice 3, de façon que le faisceau de particules émergeant de cette dernière apparaisse issu du point nodal image 31 de l'électrode retardatrice 3. L'angle d'émergence du faisceau est alors égal à l'angle d'entrée au niveau de l'électrode retardatrice 3. Le point nodal objet de l'électrode retardatrice 3 se situe sensiblement au voisinage du centre de celle-ci.

Les conditions de focalisation du faisceau de particules précédemment décrites permettent d'obtenir un minimum d'aberration chromatique. Bien entendu, ces conditions ne sont pas limitatives, et il est possible de s'écarter légèrement des conditions de fonctionnement précitées, un faisceau de particules de moins bonne qualité étant cependant obtenu.

Bien entendu, afin d'obtenir ces conditions d'aberration chromatique minimale, la lentille pré-accélératrice 2 doit être constituée de façon à présenter elle-même de faibles aberrations, tant sphérique que chromatique. Cette condition sera satisfaite dans le cas où la lentille présente une distance focale courte, ce qui sous-entend que la source de particules 1 devra normalement être située à proximité du centre optique de la lentille pré-accélératrice 2.

Conformément à l'invention, l'électrode retardatrice 3 doit permettre l'établissement, au niveau de l'axe optique situé au voisinage du centre de l'électrode retardatrice, d'un potentiel différent au plus de quelques volts du potentiel auquel l'électrode retardatrice 3 est portée par le circuit d'excitation 4 en fonction de l'amplitude des valeurs de la tension continue u et des impulsions δV auxquelles l'électrode retardatrice 3 est émise.

De manière avantageuse, mais non limitative, l'électrode retardatrice 3 peut consister en une électrode percée, l'orifice de perçage 300 étant symétrique sensiblement par rapport à l'axe optique. De façon avantageuse, l'orifice de perçage 300 présente un diamètre de perçage φ pour une épaisseur d'électrode a vérifiant sensiblement la relation φ/a ≤ 3,5. La condition précédemment citée relativement aux cotes de l'orifice et de l'électrode permet d'assurer sensiblement au centre de celle-ci, les conditions de potentiel précédemment définies.

Afin de permettre une utilisation du canon à particules électriques, objet de l'invention, avec des impulsions de commande de commutation de très faible durée, inférieure à la nanoseconde, et ceci en vue de permettre l'utilisation du canon à électrons, objet de l'invention, en commutation à très haute fréquence de commutation, plusieurs centaines de mégaHertz, il est avantageux de prévoir un agencement relatif de l'électrode retardatrice et des autres électrodes du canon à électrons, notamment électrodes pré-accélératrices 2, de façon que la capacité parasite, capacité électrostatique, entre l'électrode retardatrice 3 et les autres électrodes du canon à électrons, soit rendue minimale. De cette façon, des impulsions de commutation de très faible durée peuvent être utilisées et éventuellement des trains d'impulsions de très haute fréquence de récurrence.

Afin de réaliser une électrode retardatrice 3, de faible capacité électrostatique, l'électrode précitée peut avantageusement présenter, en vis-à-vis des autres électrodes du canon, une section réduite. En outre, la distance entre l'électrode retardatrice 3 et les autres électrodes peut être augmentée, la seule contrainte relativement à l'augmentation de cette distance, laquelle implique une focalisation du faisceau de particules 7 en conséquence, consistant en une augmentation de l'encombrement du canon à particules électriques. Typiquement, la distance entre l'électrode retardatrice 3 et les autres électrodes, peut être prise égale a un centimètre par exemple.

Différents modes de réalisation d'un canon à particules électriques, dans le cas où les particules émises sont chargées négativement, le canon constituant un canon à électrons, seront maintenant décrits en liaison avec les figures 3, 4 et 5.

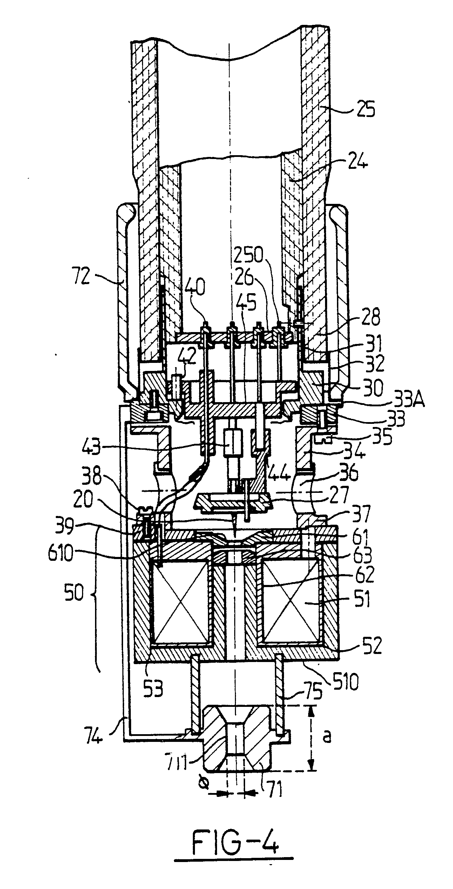

Sur les figures 3 et 4, les différents éléments du canon à électrons conforme à la présente invention, autres que l'électrode retardatrice 3, des figures 1a et 1b correspondent sensiblement aux éléments du canon à électrons décrit dans la demande de brevet européen publiée sous le numéro 0 095 969 en date du 7 décembre 1983. En ce qui concerne la description de l'agencement des différents éléments constitutifs du canon à électrons représenté sur les figures 3 et 4 notamment, on pourra se reporter utilement au texte de la demande de brevet européen précitée. Une nomenclature des différents éléments référencés sur les figures 3 et 4 sera donnée en fin de la présente description.

Conformément à la figure 3, le canon à électrons, objet de l'invention, comporte une lentille magnétique 50 constituant la lentille pré-accélératrice 2. En ce qui concerne les conditions de fonctionnement de la lentille électromagnétique 50, celles-ci correspondent aux conditions de fonctionnement décrites dans la demande de brevet européen précitée, la lentille magnétique 50 constituant une lentille à focale courte.

Ainsi qu'il apparaît en outre en figure 3, l'électrode retardatrice peut être constituée par une électrode notée 71, comprenant un corps d'électrodes creux, englobant, sensiblement, la lentille magnétique 50. L'électrode retardatrice 71 présente, en vis-à-vis de la lentille magnétique 50 une face de sortie, notée 710, munie d'un orifice 711 de sortie, disposé sensiblement sur l'axe optique. Bien entendu, l'électrode retardatrice 71 satisfait du point de vue de ses paramètres de construction géométrique relatifs à l'épaisseur a de celle-ci et au diamètre φ de l'orifice 711, à la condition permettant d'obtenir sur l'axe optique, un potentiel voisin du potentiel de la source 2, à quelques volts près, ainsi que défini précédemment. Sur la figure 3, on constatera que l'orifice 711 présente à ses extrémités un chanfrein, de manière non limitative. Dans ce cas, l'épaisseur a de l'électrode s'entend alors, compte tenue de l'existence des chanfreins, cette épaisseur devant être suffisante pour assurer les conditions de potentiel précédemment définies, au centre de l'orifice 711 sur l'axe optique.

L'électrode retardatrice 71, conformément à l'invention, est reliée au générateur d'excitation 4 par exemple, par l'intermédiaire du passage haute tension 25 et d'un contact électrique supplémentaire 250.

Une variante de réalisation, dans laquelle l'électrode retardatrice présente une capacité électrostatique faible par rapport à la lentille magnétique 51, sera maintenant décrite en liaison avec la figure 4.

Selon cette figure, l'électrode retardatrice 71, peut avantageusement être constituée par un élément de faible section, par rapport à celle de la lentille magnétique 50. L'élément précité peut avantageusement être monté sur des entretoises ou tiges isolantes 75, prenant appui sur la face 510

correspondante de la lentille magnétique. Les entretoises isolantes 75 peuvent avantageusement être constituées en un matériau, tel que de l'alumine.

En outre, la liaison électrique entre l'élément constituant l'électrode retardatrice 71 et le générateur d'excitation 4, peut avantageusement, ainsi que représentée en figure 4, être réalisée par l'intermédiaire d'un conducteur rigide par exemple, noté 74, reliant l'élément considéré à la bague ou épaulement, noté 33, 33a sur la figure 4.

Le mode de réalisation conformément à la figure 4, permet d'obtenir une électrode retardatrice dont la capacité électrostatique parasite par rapport à la lentille magnétique 51 est de l'ordre de 1 pF.

On notera, à titre d'exemple non limitatif, que la liaison de la bague 33 au générateur d'excitation 4, peut avantageusement être effectuée au moyen d'un câble pénétrant dans le passage haute tension 25, et reliant la pièce 41 qui est elle-même reliée à l'électrode retardatrice 71.

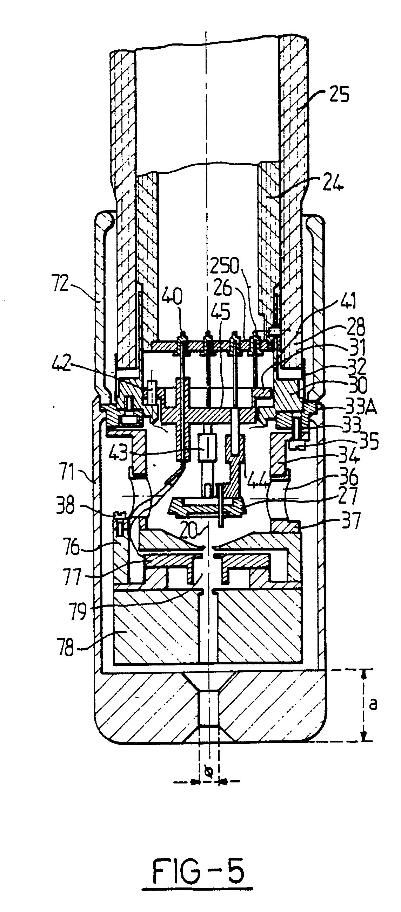

Une autre variante de réalisation du canon à particules électriques, objet de l'invention, sera décrite en liaison avec la figure 5.

Selon le mode de réalisation considéré, le canon à particules électriques représenté sur cette figure, peut avantageusement permettre l'émission d'électrons ou même d'ions, selon le mode d'émission choisi. Conformément à la figure 5, la lentille magnétique 51, précédemment utilisée, est remplacée par une lentille électrostatique constituée par les pièces notées 76, 77, 78, 79. La lentille électrostatique constitue une lentille électrostatique unipotentielle, dont la première électrode 76 et la troisième électrode 78 sont portées au potentiel permettant d'extraire les particules de la source d'émission, tandis que la deuxième électrode 77 est portée à un potentiel différent, permettant de faire varier les propriétés focalisatrices de cette lentille.

Conformément à une caractéristique avantageuse du mode de réalisation de la figure 5, et en vue d'obtenir de bonnes performances du canon à particules du point de vue des aberrations sphérique et chromatique, la lentille peut être une lentille de type dissymétrique. Dans ce cas, l'orifice de la deuxième électrode 79 sera plus proche de la première électrode 76 que de la troisième électrode 78. En outre, pour que cette lentille travaille avec une courte distance focale, la première électrode 76 sera placée à proximité de la source, de préférence à quelques millimètres. Dans ces conditions, les coefficients d'aberration sphérique et chromatique de la lentille seront de l'ordre de quelques centimètres.

Bien entendu, le mode de réalisation de la figure 5 n'est pas limité à la réalisation d'un canon à électrons. Au contraire, ce mode de réalisation permet avantageusement la réalisation d'un canon à ions à émission de champ. Pour une description plus détaillée des conditions de fonctionnement d'un canon à ions gazeux, tel que précédemment cité, on pourra utilement se reporter à la publication de W.H.ESCOVITZ, T.R. FOX, AND R.LEVI-SETTI, intitulée Scanning Transmission Ion microscope with a Field Ion Source, publiée par Pro. Nat. Acad.Sci. USA, Vol.72, No.5, pp-1826,1828, May 1975.

On a ainsi décrit un canon à particules électriques permettant l'émission pulsée de particules d'énergie comprise dans une bande d'énergie déterminée.

Le canon à particules électriques, objet de l'invention, est particulièrement remarquable, en ce que, de par la conception de son agencement, il permet par la mise en oeuvre d'une électrode retardatrice de structure particulièrement simple, la commande ou commutation du faisceau de particules "à la source", c'est-à-dire au voisinage de celle-ci, soit lorsque les particules du faisceau présentent encore un niveau d'énergie d'accélération faible. Il se distingue en cela des dispositifs de l'art antérieur connu, de manière avantageuse, en ce qu'il permet, en particulier dans le cas où le canon à particules est un canon à émission de champ et où les particules émises sont notamment des électrons, de supprimer une lentille de focalisation de la colonne de focalisation.

Bien entendu, le canon à particules électriques, objet de l'invention, n'est pas limité aux canons à émission de champ, il couvre en particulier les canons à électrons ou ions conventionnels. La suppression de la lentille de focalisation précitée permet en conséquence de réduire la longueur de la trajectoire des particules et donc d'atténuer les effets qui tendent à augmenter les dimensions de la sonde ou section du faisceau dans le plan d'analyse. Une augmentation de résolution spatiale d'analyse est ainsi obtenue.

Nomenclature des pièces essentielles représentées sur les figure 3, 4 et 5

    24 manchon de plexiglas
    25 gaine isolante en alumine - passage haute tension
    26 disque homologue
    27 embase support
    28 traversée électrique
    30 dispositif de forme annulaire
    31 bague
    33 bague
    33A épaulement vers l'extérieur
    34 cylindre alumine
    35 vis

    37 pièce de support du dispositif de focalisation magnétique
    38 vis de fixation
    39 plaque métallique
    40 traversée électrique
    41 bague interne
    42 vis
    43 organes de traversée
    44 organes de traversée
    45 disque isolant
    50 lentille magnétique
    51 bobinage
    52 carcasse étanche
    53 circuit magnétique
    60 pièce polaire
    61 pièce polaire 1ère partie
    62 pièce polaire 2ème partie
    63 entretoise
    72 partie de l'électrode intermédiaire
    250 contact électrique
    610 trou supérieur
    620 trou inférieur

## Revendications

1. Canon à particules électriques comprenant, dans une enceinte d'émission, une source d'émission (1) de particules électriques, des moyens de pré-accélération et de focalisation (2) desdites particules, caractérisé en ce qu'il comprend en outre, au voisinage desdits moyens de focalisation (2), une électrode retardatrice (3) reliée électriquement à un circuit d'excitation (4) permettant l'émission pulsée de particules d'énergie comprise dans une bande d'énergie déterminée et le filtrage en énergie de celles-ci.

2. Canon à particules selon la revendication 1, caractérisé en ce que ledit circuit (4) permet l'application à ladite électrode retardatrice (3) d'un signal d'excitation consistant en une tension continue de niveau déterminé (u) à laquelle est superposé un train d'impulsions d'amplitude ($\delta$V) permettant le blocage des particules.

3. Canon à particules selon l'une des revendications 1 ou 2, caractérisé en ce que ledit circuit (4) comprend, connectés en cascade, un générateur (40) de tension continue ajustable et un générateur d'impulsions (41).

4. Canon à particules selon l'une des revendications 1 ou 2, caractérisé en ce que ledit circuit (4) comprend, un générateur (40) de tension continue ajustable relié à l'électrode retardatrice (3) et un générateur d'impulsions (41) relié à l'électrode retardatrice (3) par un élément capacitif (42).

5. Canon à particules selon l'une des revendications précédentes, caractérisé en ce que dans le cas de particules électriques émises chargées négativement, la source d'émission est polarisée négativement (5) à une valeur (U) par rapport à la tension de référence, la source étant polarisée positivement (5) à une valeur (U) par rapport à la tension de référence dans le cas de particules chargées positivement.

6. Canon à particules selon l'une des revendications 1 à 5, caractérisé en ce que la lentille pré-accélératrice (2) est polarisée, d'une part positivement (6,U1) par rapport à la tension de référence dans le cas de l'émission de particules électriques négatives, et, d'autre part, négativement (6,U1) par rapport à la tension de référence dans le cas de l'émission de particules électriques positives.

7. Canon à particules selon l'une des revendications précédentes, caractérisé en ce que l'électrode retardatrice (3) est polarisée par rapport à la source (1) à une tension continue (u) faible, de zéro à quelques volts, positive ou négative selon la charge des particules positive ou négative, de façon à permettre le blocage des particules d'énergie inférieure en valeur absolue à e(U-u).

8. Canon à particules selon l'une des revendications précédentes, caractérisé en ce que le faisceua de particules (7) pénètre l'électrode retardatrice (3) sous un demi-angle de focalisation $\alpha$ dans un rapport inférieur à 1/5 du demi-angle d'émission $\alpha0$ des particules à l'entrée de la lentille pré-accélératrice 2, $\alpha \leq \dfrac{\alpha 0}{5}$ sensiblement.

9. Canon à particules selon l'une des revendications 1 à 8 précédentes, caractérisé en ce que le faisceau de particules (7) est focalisé par la lentille pré-accélératrice (2) au point nodal objet (30) de l'électrode retardatrice (3) de façon que le faisceau de particules émergeant apparaisse issu du point nodal image (31) de l'électrode retardatrice.

10. Canon à particules selon l'une des revendications 1 à 9 précédentes, caractérisé en ce que, afin de réaliser une électrode retardatrice de faible capacité électrostatique, ladite électrode retardatrice présente, en vis-à-vis des autres électrodes du canon, une section réduite et la distance entre électrode retardatrice (3) et les autres électrodes étant voisine de un centimètre.

11. Canon à particules selon l'une des revendications précédentes, caractérisé en ce que les particules consistant en des électrons, ledit canon comporte :
- une lentille magnétique (50), constituant la lentille pré-accélératrice (2), ladite lentille constituant une lentille à focale courte,
- une électrode retardatrice (71) constituée par un corps d'électrode creux, sensiblement, englobant ladite lentille magnétique (50), l'électrode retardatrice (71) présentant, en vis-à-vis de la lentille magnétique (50) une face de sortie (710) munie d'un orifice de sortie disposé sensiblement sur l'axe optique, le potentiel sur l'axe optique étant voisin du potentiel de la source (1) en l'absence de signaux délivrés par le circuit d'excitation (4).

12. Canon à particules selon la revendication 11, caractérisé en ce que l'électrode retardatrice (71) est constituée par un élément de faible section par rapport à celle de la lentille magnétique (50), ledit élément étant monté sur des entretoises ou tiges isolantes (75) prenant appui sur la face (510) correspondante de la lentille magnétique (50).

13. Canon à particules selon la revendication 12, caractérisé en ce que la lentille magnétique est remplacée par une lentille électrostatique (77, 78, 79).

**FIG-1a**

**FIG-1b**

EP 0 308 560 A1

FIG-2

FIG-3

FIG-4

FIG-5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | JOURNAL OF ELECTRON MICROSCOPY, vol. 32, no. 4, 1983, pages 299-304, Tokyo, JP; A. TAKAOKA et al.: "Stroboscopic TEM with time resolution of 30 mus" * Pages 299-302, paragraphe: "Pulse thermal field emission gun" * | 1 | H 01 J 37/06<br>H 01 J 37/08<br>H 01 J 37/073 |
| A | Idem | 6,7 | |
| D,Y | EP-A-0 095 969 (UNIVERSITE DE REIMS CHAMPAGNE ARDENNE) * Figures; page 4, ligne 1 - page 5, ligne 30; page 8 * | 1 | |
| A | | 9,11 | |
| A | EP-A-0 202 685 (HITACHI) * Figures; résumé * | 1 | |
| A | JOURNAL OF VACUUM SCIENCE & TECHNOLOGY B, vol. 4, no. 1, Janvier/février 1986, pages 116-119, American Vacuum Society, New York, US; G.N. LEWIS et al.: "A hydrogen field ion source with focusing optics" | 1 | |
| A | EP-A-0 086 431 (SIEMENS) * Résumé * | 1 | |
| E | FR-A-2 596 579 (UNIVERSITE DE REIMS CHAMPAGNE ARDENNE) * En entier * | 1-13 | |

DOMAINES TECHNIQUES RECHERCHES (Int. Cl.4)

H 01 J 37/00
H 01 J 3/00

Le présent rapport a été établi pour toutes les revendications

| Lieu de la recherche | Date d'achèvement de la recherche | Examinateur |
|---|---|---|
| LA HAYE | 18-05-1988 | SCHAUB G.G. |